# EUROPEAN PATENT SPECIFICATION

(11) **EP 4 391 091 B1**
(45) Date of publication and mention of the grant of the patent: **13.05.2026**
(21) Application number: 23855808.4
(22) Date of filing: 22.09.2023
(51) Int. Cl.: H10F 77/70, H10F 71/00, H10F 10/165

(54) **METHOD FOR MANUFACTURING A SOLAR CELL**
VERFAHREN ZUR HERSTELLUNG EINER SOLARZELLE
PROCÉDÉ DE FABRICATION D'UNE CELLULE SOLAIRE

(30) Priority: 09.11.2022 CN 202211399762
(43) Date of publication of application: 26.06.2024
(73) Proprietor: Tongwei Solar (Meishan) Co., Ltd., Meishan, Sichuan 620041 (CN)
(72) Inventor: FANG, Mingliang, Meishan, Sichuan 620041 (CN); HOU, Kun, Meishan, Sichuan 620041 (CN); LIU, Zonggang, Meishan, Sichuan 620041 (CN); MA, Lie, Meishan, Sichuan 620041 (CN)
(74) Representative: Marks & Clerk LLP
(86) International application number: PCT/CN2023/120743
(87) International publication number: WO 2024/098977

(56) References cited:
- CN-A- 102 938 431
- CN-A- 104 766 906
- CN-A- 108 231 540
- CN-A- 110 491 971
- CN-A- 115 832 115
- JP-A- 2013 165 114
- LOZAC'H MICKA�L ET AL: "Role of silicon surface, polished <100> and <111> or textured, on the efficiency of double-sided TOPCon solar cells", vol. 28, no. 10, 25 June 2020 (2020-06-25), Hoboken, USA, pages 1001 - 1011, XP055916906, ISSN: 1062-7995, Retrieved from the Internet <URL:https://onlinelibrary.wiley.com/doi/full-xml/10.1002/pip.3304> DOI: 10.1002/pip.3304

## Description

### TECHNICAL FIELD

The present disclosure relates to the technical field of solar cells, and specifically, to a method for manufacturing a solar cell.

### BACKGROUND

Currently on the market, most tunnel oxide passivated contact (TOPCon) cells are based on P-type monocrystalline silicon. However, the photoelectric conversion efficiency of the P-type TOPCon cells is difficult to reach above 23.5%, and the efficiency in the industry is currently close to the limit. Cells based on N-type silicon have higher conversion efficiency. Developing and producing N-type high-efficiency cells is an effective way to improve the photoelectric conversion efficiency.

For N-TOPCon cells, the current mainstream preparation process includes: silicon wafer - texturing - boron diffusion - backside etching - tunneling oxidation - in-situ doped amorphous silicon - wraparound plating - front side aluminum oxide - front side silicon nitride - back side silicon nitride - printing and sintering - testing and sorting.

However, the inventors found that TOPCon cells prepared using traditional preparation process often turned black during an electro luminescence (EL) test. Moreover, the prepared TOPCon cells are prone to problems such as blackening and low efficiency.

Lozac'h Mickael et al: "Role of silicon surface, polished 〈100〉 and (111) or textured, on the efficiency of double-sided TOPCon solar cells"; Progress in Photovoltaics: Research and Applications, Vol. 28, No. 10, 25 June 2020, pages 1001-1011, XP055916906 discusses the role of the silicon surface and orientation on double-sided TOPCon solar cells properties. The solar cells of front and rear, (p) and (n), poly-Si/SiOx stack, fabricated on polished surfaces oriented 〈100〉 and (111) and pyramid textured surfaces, are characterized as a function of the thickness of an ultrathin SiOx layer, controlled at atomic scale from one- to four-cycle atomic layer deposition (ALD). It is stated therein that the optimized thickness of the ultrathin SiOx is about 1.1 ± 0.1 nm, corresponding to a two-cycle ALD, regardless of the surface and orientation of the c-Si substrate. The open-circuit voltage is about 10 mV higher on the polished (100) -oriented surface, associated with lower defect density at the interface of SiOx/c-Si. On the other hand, the contact resistance is much lower, about 0.45 Ω /cm2, on the polished (111) - oriented surface. On textured surfaces, a photoconversion efficiency of 19.1% is demonstrated for the double-sided TOPCon structure strictly for a SiOx thickness with two-cycle ALD.

### SUMMARY

Based on the above-mentioned shortcomings, the present application provides a method for manufacturing a solar cell, to partially or fully improve or even solve the problem of blackening of solar cells in related arts.

### This application is implemented as follows:

In a first aspect, an embodiment of the present application provides a method for preparing a solar cell. The preparation method includes: performing a texturing process and a boron or phosphorus diffusion process sequentially. Between the texturing process and the boron or phosphorus diffusion process, the preparation method further includes: heating a silicon wafer that has been wet-textured loaded in a wafer cassette to form a first oxide layer on both front and back sides of the silicon wafer to absorb impurities in the silicon wafer; and removing the first oxide layer on the front and back sides of the silicon wafer; wherein the heating method comprises: heating the textured silicon wafer (10) in a pure oxygen environment to a first preset temperature, and preserving the temperature for a first preset time; wherein the first preset temperature is within a range of 600°C to 800°C, and the first preset time is within a range of 30s to 60s.

Optionally, a thickness of the first oxide layer is within a range of 4 nm to 5 nm.

During the above implementation, after using the wafer cassette to load the wet-textured silicon wafer, some impurities such as additives and alkali crystals will inevitably remain at the contact area between the silicon wafer and the teeth position of the wafer cassette, so there will be defects at the contact position between the silicon wafer and the wafer cassette. After wet texturing the silicon wafer loaded in the wafer cassette, the silicon wafer is heated to form the first oxide layer on the front and back sides of the silicon wafer to absorb the impurities such as organic matter and alkali crystals attached to the surface of the silicon wafer. Then, the first oxide layer adsorbed with the impurities is removed, which can improve the cleanliness of the surface of the silicon wafer, thereby further improving the uniformity of the subsequent boron diffusion or phosphorus diffusion process, and improving the quality and efficiency of the solar cell. If the subsequent boron diffusion or phosphorus diffusion process is directly performed on the textured cell, the defects at the contact position between the silicon wafer and the teeth of the wet wafer cassette will be multiplied after the boron diffusion process. Under the EL test, severe blackening appeared at this position, affecting the yield and efficiency of the solar cell.

Referring to the first aspect, in a first possible implementation of the first aspect of the application, the silicon wafer is an n-type monocrystalline silicon wafer, and the solar cell includes a passivation/anti-reflection film, a passivation layer, a p-type emitter, an n-type monocrystalline silicon wafer substrate, a tunneling oxide layer, an n-type polysilicon film, and an anti-reflection film that are stacked.

The boron diffusion process of the N-TOPCon cell needs to be performed at a larger opening voltage and higher temperature. For example, the opening voltage is above 700 mV, the temperature of the boron diffusion process rises to 1000°C. In this case, the N-TOPCon cell is more sensitive to an impact of impurity contamination, and the blackening phenomenon is more obvious during the EL test. Therefore, the above method has a more significant improvement effect on the N-TOPCon cell. In the above implementation, in the preparation process of the N-TOPCon cell, the n-type monocrystalline silicon wafer after wet texturing is heated to form the first oxide layer to absorb the impurities, and then the boron diffusion process after removing the first oxide layer on both sides of the silicon wafer is performed, which can improve the quality and efficiency of the prepared N-TOPCon cell.

Referring to the first aspect, in a third possible implementation of the first aspect of the application, the first preset temperature is within a range of 700°C to 800°C.

During the above implementation, the wet-textured silicon wafer is heated to the first preset temperature of 600°C to 800°C and preserved for the first preset time of 30s to 60s, which can ensure that the first oxide layer is formed to absorb the impurities on the surface of the silicon wafer. Meanwhile, it can not only avoid that the impurity cannot be effectively adsorbed due to the heating temperature being too low or the holding time being too short, but also prevent the impurities adsorbed on the first oxide layer from diffusing into the interior of the silicon wafer due to the heating temperature being too high or the holding time being too long, thus affecting the quality and efficiency of the solar cell.

The textured silicon wafer is heated to 700°C to 800°C, which can further reduce the impurities in the silicon wafer, and improve the quality and efficiency of the solar cell.

Referring to the first aspect, in a fourth possible implementation of the first aspect of the application, the method of removing the first oxide layer on the front and back sides of the silicon wafer includes: cleaning the silicon wafer using a cleaning agent. A cleaning time is within a range of 30s to 50s, and the cleaning agent includes HF.

Optionally, the cleaning agent includes the HF with a volume concentration of 15% to 30%.

The silicon wafer is heated to form the first oxide layer on the surface of the silicon wafer, to adsorb the impurities on the surface of the silicon wafer to the first oxide layer. In the above implementation, using the cleaning agent containing the HF to clean the silicon wafer for 30s to 50s can remove the first oxide layer on the surface of the silicon wafer and the impurities adsorbed on the first oxide layer, thereby improving the quality and efficiency of solar cells obtained by the subsequent boron diffusion or phosphorus diffusion process.

Using HF with a volume concentration of 15% to 30% can reduce the amount of HF while removing the first oxide layer and the impurities, thereby reducing the preparation cost of solar cells.

Referring to the first aspect, in a fifth possible implementation of the first aspect of the application, the cleaning agent further includes HCl.

Optionally, the cleaning agent further includes the HCl with a volume concentration of 5% to 10%.

Optionally, the cleaning agent includes the HF and the HCl with a volume ratio of 3:1.

In the above implementation, using an appropriate ratio of HF and HCl, the first oxide layer and the impurities adsorbed on the first oxide layer can be effectively removed, and the amount of HF and HCl can also be reduced to prevent the HF and HCl from affecting the silicon wafer (for example, over-corrosion destroys the texturing surface), thereby reducing the preparation cost of solar cells.

Referring to the first aspect, in a sixth possible implementation of the first aspect of the application, after the cleaning the silicon wafer using the cleaning agent, a second oxide layer is formed on a surface of the silicon wafer, and the boron or phosphorus diffusion process is performed on the silicon wafer formed with the second oxide layer on a surface thereof.

Optionally, the method of forming the second oxide layer includes: purging the silicon wafer with ozone.

In the above implementation, the second oxide layer is re-formed on the surface of the silicon wafer after removing the first oxide layer with the cleaning agent, which can form a protective layer on the surface of the silicon wafer, and further reduce the impurity contamination, making the subsequent boron diffusion or phosphorus diffusion process more uniform.

In a second aspect which is not part of the present invention, a solar cell is obtained, which is prepared according to the method for preparing the solar cell provided in the first aspect.

In the above implementation, in the solar cell preparation process, the wet-textured silicon wafer is heated to form an oxide layer, which can absorb the impurities produced on the silicon wafer due to the process equipment such as the wafer cassette during texturing. Further, the oxide layer absorbed with the impurities is removed by using the cleaning agent, so that the solar cell subsequently prepared through the process such as the boron diffusion or phosphorus diffusion has better quality and conversion efficiency.

Referring to the second aspect, in a first possible implementation of the second aspect of the application, the solar cell includes a passivation/anti-reflection film, a passivation layer, a p-type emitter, an n-type silicon wafer substrate, a tunneling oxide layer, an n-type polysilicon film, and an anti-reflection film that are stacked. The solar cell is of a quadrilateral thin plate structure, with a first side in contact with the wafer cassette and a second side not in contact with the wafer cassette during texturing, and a degree of blackening of the first side and a degree of blackening of the second side during an EL test are the same.

The second side of the N-TOPCon cell that is not in contact with the wafer cassette during texturing generally does not appear to be blackened in the EL test, while the first side of the N-TOPCon cell that is in contact with the wafer cassette during texturing generally exhibits the wafer cassette mark and blackening during the EL test. In the above implementation, the first side in contact with the wafer cassette and the second side not in contact with the wafer cassette have the same degree of blackening during the EL test in the N-TOPCon cell provided in this embodiment, in other words, there is no blackening of the wafer cassette mark at any position on the first side, and the wet wafer cassette mark can be effectively removed, and the quality and conversion efficiency of the N-TOPCon cell can be improved.

In a third aspect which is not part of the present invention, an implementation of the present application provides a cell assembly, including a plurality of solar cells provided by the second aspect.

In the above implementation, the solar cell provided by the second aspect can avoid the occurrence of the wet wafer cassette mark and has high quality and conversion efficiency. Therefore, the cell assembly including the plurality of solar cells provided by the second aspect also has good conversion efficiency.

### BRIEF DESCRIPTION OF THE DRAWINGS

In order to describe the technical solutions of the embodiments of the present disclosure or the conventional art more clearly, the accompanying drawings required for describing the embodiments or for describing the conventional art will be briefly introduced as follows.
FIG. 1 is a schematic cross-sectional view of a silicon wafer after wet texturing in the prior art.
FIG. 2 is a schematic cross-sectional view of a silicon wafer formed with a first oxide layer according to the present application.
FIG. 3 is a schematic cross-sectional view of the silicon wafer after removing the first oxide layer according to the present application.
FIG. 4 is a flow chart illustrating a preparation process of a TOPCon cell according to an embodiment of the present application.
FIG. 5 is a diagram illustrating an EL test of a TOPCon cell according to Example 1 of the present application.
FIG. 6 is a diagram illustrating an EL test of a TOPCon cell according to Example 2 of the present application.
FIG. 7 is a diagram illustrating an EL test of a TOPCon cell according to Comparative Example 1 of the present application.
FIG. 8 is a diagram illustrating an EL test of a TOPCon cell according to Comparative Example 2 of the present application.

### Reference numerals:

10: textured silicon wafer; 20: impurities; 30: first oxide layer.

### DETAILED DESCRIPTION OF THE EMBODIMENTS

The implementation solutions of the present application will be described in detail below with reference to embodiments, but those skilled in the art will understand that the following embodiments are only used to illustrate the present application and should not be regarded as limiting the scope of the present application. If the specific conditions are not specified in the embodiments, the conditions should be carried out according to the conventional conditions or the conditions recommended by the manufacturer. If the manufacturer of the reagents or equipment used is not indicated, they are all conventional products that can be purchased commercially.

The following is a detailed description of a method for preparing a TOPCon cell and a cell assembly, according to an embodiment of the present application.

For N-TOPCon cells, the current mainstream preparation process includes: N-type silicon wafer - texturing - boron diffusion - backside etching - tunneling oxidation - in-situ doped amorphous silicon - wraparound plating - front side aluminum oxide - front side silicon nitride - back side silicon nitride - printing and sintering - testing and sorting.

However, the inventors have found that the TOPCon cells prepared using traditional preparation process often turned black during an EL test.

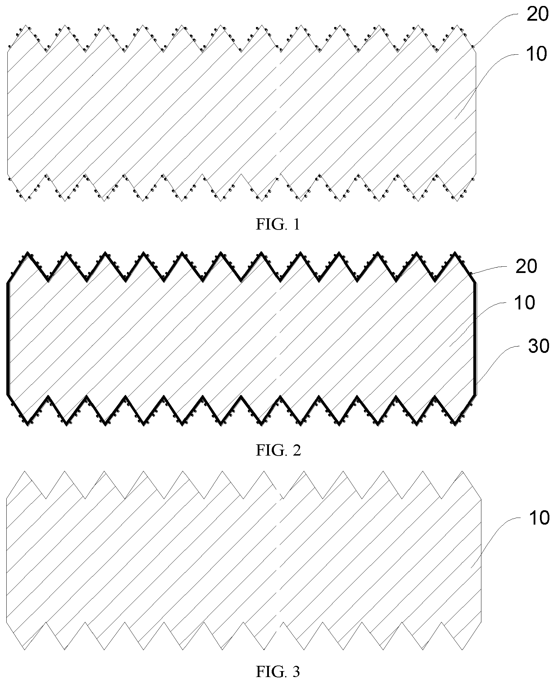

The inventors analyzed the reason for the blackening phenomenon and believed that in the development and production of N-type high-efficiency TOPCon cells, a silicon wafer is loaded in a wafer cassette during wet texturing, and the wafer cassette and the silicon wafer are soaked in a texturing tank together. There are slight residues of additive organic matter and alkali crystals at the contact position between the textured silicon wafer 10 and the teeth of the wafer cassette. Impurities 20 such as additive organic matter and alkali crystals remaining on the surface of the textured silicon wafer 10 are shown in FIG. 1. During the subsequent high-temperature process of boron diffusion, this defect was amplified, causing the position where the silicon wafer contacts the teeth of the wafer cassette to appear to be blackened during the EL test.

The inventors believed that in the preparation process of the TOPCon cells, the wafer cassette mark that appears during texturing will reduce the uniformity of the subsequent boron diffusion or phosphorus diffusion process, thereby reducing the yield and efficiency of the TOPCon cells.

Based on this, the inventors provide a method for preparing a TOPCon cell, including oxidation impurity removal and cleaning processes performed between a wet texturing process and a boron or phosphorus diffusion process. The oxidation impurity removal and cleaning processes include: heating a silicon wafer that has been wet-textured loaded in a wafer cassette to form a first oxide layer on both front and back sides of the silicon wafer to absorb impurities in the silicon wafer; and removing the first oxide layer on the front and back sides of the silicon wafer.

After wet texturing the silicon wafer loaded in the wafer cassette, the textured silicon wafer 10 is heated, so as to form a first oxide layer 30 on the surface of the textured silicon wafer 10 to absorb the impurities 20, such as organic matter and alkali crystals attached to the surface of the textured silicon wafer 10. A schematic cross-sectional view of the first oxide layer 30 formed on the surface of the textured silicon wafer 10 after wet texturing is shown in FIG. 2 (for easy illustration, the impurities 20 are drawn on the upper surface of the first oxide layer 30, which do not mean that the impurities 20 are located on the surface of the first oxide layer 30. The impurities 20 may also be located inside the first oxide layer 30).

Then, the first oxide layer 30 adsorbed with the impurities 20 is removed, which can improve the cleanliness of the surface of the textured silicon wafer 10, thereby further improving the uniformity of the subsequent boron diffusion or phosphorus diffusion process, avoiding wet wafer cassette mark in the TOPCon cell, and improving the quality and efficiency of the TOPCon cell. If these impurities 20 are not eliminated or improved, these defects at the contact position between the silicon wafer and the teeth of the wet wafer cassette will be multiplied after the boron diffusion process, resulting in severe blackening defects at this position under the EL test, thus seriously affecting the yield and efficiency of the TOPCon cell. A schematic cross-sectional view of the silicon wafer after removing the first oxide layer 30 adsorbed with the impurities 20 is shown in FIG. 3.

The method for preparing the TOPCon cell according to an embodiment of the present application will be further described in detail below with reference to the accompanying drawing.

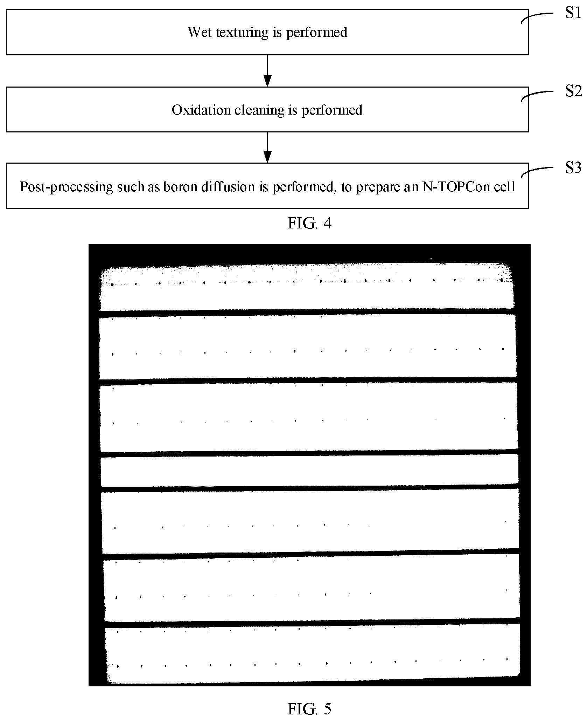

Referring to FIG. 4, this embodiment provides a method for preparing the TOPCon cell, including:

In step S1, a texturing process is performed.

The front and back sides of the silicon wafer are textured to form a textured surface on the surface of the silicon wafer, so as to increase the reflectivity of light and remove some impurities from the silicon matrix.

During texturing, the silicon wafer may be loaded in a wafer cassette, and the wafer cassette loaded with the silicon wafer is immersed in a texturing tank containing a texturing agent such as KOH. The texturing agent in the texturing tank may be the KOH with a volume concentration of 1% to 20%, and a temperature of the texturing step may range from 40°C to 80°C. Then, the textured silicon wafer is acid washed, water washed, slowly pulled, and dried at a temperature of 80°C to 100°C sequentially. HF with a volume concentration of 1% to 30% may be used for acid washing.

In step S2, an oxidation cleaning process is performed.

The textured silicon wafer 10 that has been wet-textured loaded in the wafer cassette is heated to form the first oxide layer 30 to absorb the impurities 20 on the surface of the textured silicon wafer 10. Then the first oxide layer 30 on the front and back sides of the textured silicon wafer 10 is removed.

During the texturing process, after wet texturing the silicon wafer loaded in the wafer cassette to obtain the textured silicon wafer 10, some impurities 20 such as additives and alkali crystals will inevitably remain at the contact area between the textured silicon wafer 10 and the teeth position of the wafer cassette, and there will be defects at the contact position between the silicon wafer and the wafer cassette. For example, in a quadrilateral plate-shaped N-TOPCon cell, the N-TOPCon cell has a first side in contact with the wafer cassette and a second side not in contact with the wafer cassette. Some impurities 20 such as additives and alkali crystals remain on the first side in contact with the wafer cassette, thus forming defects on the first side. If these defects are not improved, these defects will be amplified in the subsequent boron diffusion process, causing the first side for contacting with the wafer cassette to appear to be blackened during the EL test, thus affecting the quality and efficiency of the N-TOPCon cell.

After wet texturing the silicon wafer loaded in the wafer cassette, the textured silicon wafer 10 is heated to form the first oxide layer 30 on the surface of the textured silicon wafer 10 to absorb the impurities 20 such as organic matter and alkali crystals attached to the surface of the textured silicon wafer 10. Then, the first oxide layer 30 adsorbed with the impurities 20 is removed, which can improve the cleanliness of the surface of the textured silicon wafer 10, thereby further improving the uniformity of the subsequent boron diffusion or phosphorus diffusion process, and improving the quality and efficiency of the N-TOPCon cell.

In the present invention, the textured silicon wafer 10 is heated to a first preset temperature ranging from 600°C to 800°C, and the temperature is preserved for a first preset time ranging from 30s to 60s.

Exemplarily, the first preset temperature includes, but is not limited to, one of 600°C, 650°C, 700°C, 750°C and 800°C or a range between any two.

Exemplarily, the first preset time includes but is not limited to, one of 30s, 35s, 40s, 50s and 60s or a range between any two.

The textured silicon wafer 10 is heated to the first preset temperature of 600°C to 800°C and preserved for the first preset time of 30s to 60s, which can ensure that the first oxide layer 30 is formed to absorb the impurities 20 on the surface of the textured silicon wafer 10. Meanwhile, it can not only avoid that the impurity 20 cannot be effectively adsorbed due to the heating temperature being too low or the holding time being too short, but also prevent the impurities 20 adsorbed on the first oxide layer 30 from diffusing into the interior of the textured silicon wafer due to the heating temperature being too high or the holding time being too long, thus affecting the quality and efficiency of the N-TOPCon cell.

In order to improve the oxidation treatment efficiency of the textured silicon wafer 10 and control the oxidation impurity absorption quality of the textured silicon wafer 10, in some possible implementations, a stepping heating furnace can be used to heat the textured silicon wafer 10. By setting the length of the heating furnace and the conveying speed (roller conveyance) of the textured silicon wafer 10 in the heating furnace, the heating time of the textured silicon wafer 10 is controlled, thereby reducing the error in the oxidation treatment process.

In the present invention, the textured silicon wafer 10 is placed in a pure oxygen environment for heating Since an oxidation rate and a diffusion rate of impurities will change in the pure oxygen environment, relevant personnel can slightly reduce or increase the first preset temperature, and slightly extend or shorten the holding time.

The present application does not limit how to remove the first oxide layer 30 adsorbed with the impurities 20 on the surface of the textured silicon wafer 10, and relevant personnel can make corresponding adjustments as needed.

In some possible implementations, the textured silicon wafer 10 with the first oxide layer 30 formed on the surface can be cleaned using a cleaning agent including HF.

Using the cleaning agent containing the HF to clean the surface of the textured silicon wafer 10 can not only effectively remove the first oxide layer 30 and the impurities 20, but also modify a textured surface of the textured silicon wafer 10, and passivate the textured silicon wafer 10.

The present application does not limit the specific composition of the cleaning agent. In some possible implementations, the cleaning agent further includes HCl.

For example, the cleaning agent includes the HF with a volume concentration of 15% to 30% and the HCl with a volume concentration of 5% to 10%.

Further, the cleaning agent includes the HF with a volume concentration of 15% to 30% and the HCl with a volume concentration of 5% to 10% with a volume ratio of 3:1.

The present application does not limit the specific cleaning time. In some possible implementations, the textured silicon wafer 10 is cleaned using the cleaning agent including the HF with a volume concentration of 15% to 30% and the HCl with a volume concentration of 5% to 10% with a volume ratio of 3:1, and the cleaning time is within a range of 30s to 50s. Exemplarily, the cleaning time includes but is not limited to, one of 30s, 35s, 40s, 50s and 60s or a range between any two.

In order to further improve the quality and efficiency of the prepared N-TOPCon cell, in some possible implementations, a thin second oxide layer can be formed on the surface of the textured silicon wafer 10 after removing the first oxide layer 30, to perform surface modification and passivation treatment, making the subsequent boron diffusion treatment process more uniform.

Furthermore, a second oxide layer can be formed on the surface of the silicon wafer by purging ozone. Alternatively, the second oxide layer is formed by passivation treatment using nitric acid.

In step S3, a post-processing process is performed on the textured silicon wafer 10 obtained in step S2, to prepare an N-TOPCon cell.

The step S3 can use the conventional N-TOPCon cell preparation process. In the preparation process of the N-TOPCon cell in the example of this application, without changing the original N-TOPCon cell preparation steps, an oxidation cleaning step is performed between the texturing process and the boron diffusion process, so that the wafer cassette mark produced during wet texturing can be removed and the uniformity of the subsequent boron diffusion can be improved, thereby improving the quality of the prepared N-TOPCon cell.

In the present application, the step of post-processing the silicon wafer after oxidation cleaning in step S2 is feasible, as long as the N-TOPCon cell can be prepared. This application does not specifically limit the post-processing process.

Exemplarily, a boron diffusion process is performed on the textured silicon wafer 10 after oxidation and impurity removal to form a PN junction. The step of boron diffusion of the textured silicon wafer 10 may include: placing the textured silicon wafer 10 in a boron diffusion tube, introducing a boron source at a temperature of 700°C to 900°C for 20s to 1000s, and then pushing the junction at a temperature of 900°C to 1200°C for 100s to 5000s.

Exemplarily, an etching process is performed on the boron-diffused silicon wafer. The etching method may include: placing the boron-diffused silicon wafer in an etching tank containing etchants such as HNO₃ and HF.

Exemplarily, a tunneling oxidation process is performed on the etched silicon wafer. The step of the tunneling oxidation includes: heating the etched silicon wafer to 600°C for oxidation to form a tunneling oxide layer on the back side of the silicon wafer.

Exemplarily, a doping amorphous silicon process is performed on the tunnel-oxidized silicon wafer. The step of doping amorphous silicon includes: introducing a mixed gas of PH₃ and SiH₄ at a process temperature of 400°C, to in-situ dope amorphous silicon into the silicon wafer obtained after the tunneling oxidation step.

Exemplarily, an annealing process is performed on the above silicon wafer doped with amorphous silicon. The annealing step includes: placing the silicon wafer at a temperature of 800°C for about 60 minutes for constant temperature annealing, so that the doped amorphous silicon becomes phosphorus-doped polysilicon.

Exemplarily, a wraparound plating process is performed on the above annealed silicon wafer. The step of wraparound plating include: growing silicon oxide on the back side of the annealed silicon wafer, washing silicon oxide on a front wraparound plating area of the silicon wafer with HF, and then placing the silicon wafer in an alkali polishing tank (a volume concentration of KOH is 1% to 20%, a temperature is 40°C to 90°C, and an amount of alkali polishing additive is 2L to 20L), to perform alkali polishing to remove polysilicon wraparound plating on the front side of the silicon wafer.

Exemplarily, a front side deposition of aluminum oxide, a front side deposition of silicon nitride, and a back side deposition of silicon nitride are performed on the silicon wafer after removing the wraparound plating. The step of depositing front side aluminum oxide includes: depositing front side aluminum oxide by thermal atomic deposition (ALD), and a process temperature is within a range of 200°C to 250°C. The step of depositing front side silicon nitride and back side silicon nitride includes: depositing a front side silicon nitride film and a back side silicon nitride film by using a plasma chemical vapor deposition method, and introducing NH₃ and SiH₄ gases during deposition.

Exemplarily, a screen-printing process and a sintering process are performed on the silicon wafer deposited with front and back silicon nitride films.

In some possible implementations, an embodiment of this application provides a method for preparing a P-TOPCon cell, including: texturing: wet alkali texturing; oxidation cleaning: heating the textured silicon wafer 10, to form a first oxide layer 30, and removing the first oxide layer 30 adsorbed with impurities 20 by using a cleaning agent; phosphorus diffusion: phosphorus doping; etching: polishing the back side of the silicon wafer and removing edge PN junctions; front/back film: plating front-side/back-side passivation anti-reflection film; and screen-printing: drying and sintering the back silver paste, aluminum paste and front silver paste that have been screen printed to form a contact electrode.

The above preparation method provides a TOPCon cell.

Exemplarily, the preparation method as shown in FIG. 4 provides an N-TOPCon cell.

The N-TOPCon cell is of a quadrilateral thin plate structure, with a first side in contact with the wafer cassette and a second side not in contact with the wafer cassette during texturing. Generally, the second side that is not in contact with the wafer cassette usually does not appear to be blackened, while the second side in contact with the wafer cassette will exhibit the wafer cassette mark. Therefore, the degree of blackening between the two is quite different, in other words, the second side is almost not blackened, and the first side has obvious abnormal blackening. In the N-TOPCon cell provided in this embodiment, neither the first side nor the second side will appear to be blackened during the EL test, which can avoid the occurrence of the wafer cassette mark.

An implementation of this application further provides a cell assembly. The cell assembly includes a plurality of N-TOPCon cells described above.

This application does not limit the specific arrangement of the cell assembly, and relevant personnel can make corresponding adjustments as needed.

In a possible implementation, the cell assembly includes a plurality of N-TOPCon cells, and the plurality of N-TOPCon cells may be connected in series.

Exemplarily, the photocell assembly includes 64 or 72 N-TOPCon cells.

In a possible implementation, the cell assembly further includes a photovoltaic glass layer. The photovoltaic glass layer covers an upper surface of the N-TOPCon cell to protect the N-TOPCon cell. The photovoltaic glass in the photovoltaic glass layer is also called photoelectric glass. The photovoltaic glass is a tempered low-iron glass with very good light transmittance and high hardness, so it can adapt to large temperature differences between day and night and harsh weather environments, thereby protecting the N-TOPCon cell.

Likewise, in a possible implementation, the cell assembly further includes a photovoltaic panel. The photovoltaic panel has good insulation, waterproofness and aging resistance. The photovoltaic panel is placed on the back side of the N-TOPCon cell to further protect the N-TOPCon cell. The photovoltaic panel can also be made from tempered glass.

Further, in a possible implementation, the cell assembly further includes an ethylene vinyl acetate (EVA) film layer with good light transmittance. Since the N-TOPCon cell is very fragile, the photovoltaic glass layer cannot be directly attached to the upper surface of the N-TOPCon cell, and the EVA film is required to play a bonding role in the middle.

In order to improve the stability of the cell assembly, the cell assembly can also be provided with a frame, and the plurality of N-TOPCon cells are mounted in the frame to support and protect the cell assembly.

The N-TOPCon cell will be described in detail below with reference to examples.

### Example 1

Example 1 of the present application provided an N-TOPCon cell, which was prepared by the following method.

Using the N-type silicon wafer as the original silicon wafer, the silicon wafer was texturized, oxidized and cleaned, boron diffused, alkali polished, doped with polysilicon, annealed, cleaned by using a RCA cleaning method, plated front and back sides silicon nitride, and screen printed sequentially.

The texturing conditions were as follows: a volume concentration of KOH was 20%, and a texturing temperature was 40°C. The oxidation cleaning conditions were as follows: the textured silicon wafer was heated to 600°C and preserved the temperature for 60 seconds, and HF with a volume concentration of 15% and HCL with a volume concentration of 5% were configured with a cleaning agent in a volume ratio of 3:1, cleaning for 50 seconds. The boron diffusion conditions were as follows: the oxidized and cleaned silicon wafer was placed in a boron diffusion tube, and a boron source was introduced at a temperature of 700°C for 500 seconds, and then the junction was pushed at a temperature of 1000°C for 1000 seconds. The conditions for alkali polishing were as follows: the above silicon wafer was placed in an alkali polishing tank (KOH with a volume concentration of 10%, a temperature of 40°C, and an amount of 10L of alkali polishing additive). The conditions for doping polysilicon were as follows: a mixed gas of PH₃ and SiH₄ was introduced, and a process temperature was 600°C. The annealing conditions were as follows: constant temperature annealing was performed at a temperature of 850°C for 60 minutes. The RCA conditions were as follows: the silicon oxide was washed away with HF with a volume concentration of 20%. The conditions for plating the front and back sides silicon nitride were as follows: the front and back sides silicon nitride films were deposited on the surface of the silicon wafer by using a plasma chemical vapor deposition method, NH₃ and SiH₄ gases were introduced during deposition, a process temperature was 500°C, and a pressure was 200Pa. The screen-printing conditions were as follows: the N-TOPCon cell was prepared by screen printing using a DUP screen.

### Example 2

Example 2 of the present application provided an N-TOPCon cell. The difference from Example 1 was that the textured silicon wafer was heated to 800°C and preserved the temperature for 30 seconds in the preparation method.

### Comparative Example 1

Comparative Example 1 of the present application provided an N-TOPCon cell. The difference from Example 1 was that the preparation method includes texturing, boron diffusion, alkali polishing, polysilicon doping, annealing, RCA cleaning, front and back sides silicon nitride plating, and screen printing. The specific conditions of each process were the same as in Example 1.

### Comparative Example 2

Comparative Example 2 of the present application provided an N-TOPCon cell. The difference from Example 1 was that the textured silicon wafer was heated to 400°C during oxidation cleaning.

### Comparative Example 3

Comparative Example 3 of the present application provided an N-TOPCon cell. The difference from Example 1 was that the textured silicon wafer was heated to 1000°C during the oxidation cleaning.

### Example

An EL test was performed on the N-TOPCon cells provided in Examples 1 and 2 and Comparative Examples 1 and 2, to observe their blackening phenomenon.

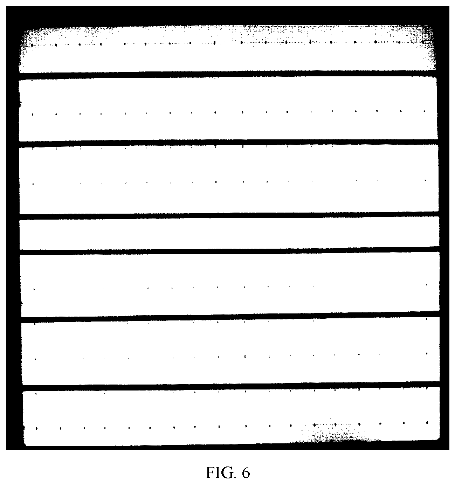

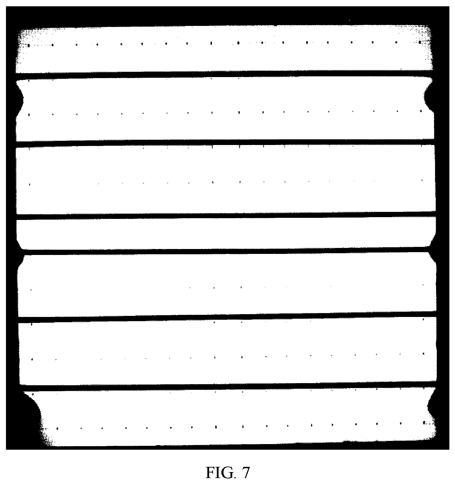

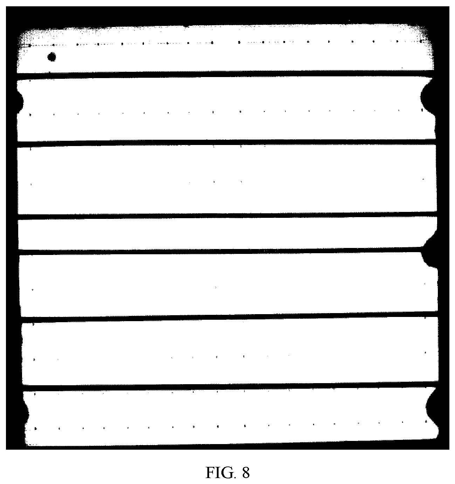

The test result of Example 1 is shown in FIG. 5, the test result of Example 2 is shown in FIG. 6, the test result of Comparative Example 1 is shown in FIG. 7, and the test result of Comparative Example 2 is shown in FIG. 8.

The results are analyzed as follows, according to the comparison diagrams between Examples 1 to 2 and Comparative Example 1, it can be seen that the N-TOPCon cells provided by Examples 1 and 2 of the present application did not appear to be blackened during the EL test, which can avoid the occurrence of the wafer cassette mark. The N-TOPCon cell provided by Comparative Example 1 has an obvious wafer cassette mark.

According to the comparison diagrams between Examples 1 to 2 and Comparative Example 2, it can be seen that the N-TOPCon cell provided by Comparative Example 2 still has an obvious wafer cassette mark.

The above descriptions are only preferred embodiments of the present application and are not intended to limit the present application. Accordingly, the scope of the invention is defined by the appended claims.

## Claims

1. A method for preparing a solar cell, the preparation method comprising: performing a texturing process and a boron or phosphorus diffusion process sequentially, wherein the preparation method further comprises, between the texturing process and the boron or phosphorus diffusion process:
heating a silicon wafer (10), that has been wet-textured loaded in a wafer cassette, to form a first oxide layer (30) on both front and back sides of the silicon wafer (10) to absorb impurities in the silicon wafer (10); and
removing the first oxide layer on the front and back sides of the silicon wafer (10);
**characterized in that** the heating method comprises: heating the textured silicon wafer (10) in a pure oxygen environment to a first preset temperature, and preserving the temperature for a first preset time;
wherein the first preset temperature is within a range of 600°C to 800°C, and the first preset time is within a range of 30s to 60s.

2. The method for preparing the solar cell according to claim 1, wherein a thickness of the first oxide layer (30) is within a range of 4 nm to 5 nm.

3. The method for preparing the solar cell according to claim 1, wherein the silicon wafer (10) is an n-type monocrystalline silicon wafer, and the solar cell comprises a passivation/anti-reflection film, a passivation layer, a p-type emitter, an n-type monocrystalline silicon wafer substrate, a tunneling oxide layer, an n-type polysilicon film, and an anti-reflection film that are stacked.

4. The method for preparing the solar cell according to claim 1, wherein the first preset temperature is within a range of 700°C to 800°C.

5. The method for preparing the solar cell according to claim 1, wherein the method of removing the first oxide layer (30) on the front and back sides of the silicon wafer (10) comprises: cleaning the silicon wafer (10) using a cleaning agent, wherein a cleaning time is within a range of 30s to 50s, and the cleaning agent comprises HF.

6. The method for preparing the solar cell according to claim 5, wherein the cleaning agent comprises the HF with a volume concentration of 15% to 30%.

7. The method for preparing the solar cell according to claim 6, wherein the cleaning agent further comprises HCl.

8. The method for preparing the solar cell according to claim 7, wherein the cleaning agent further comprises the HCl with a volume concentration of 5% to 10%.

9. The method for preparing the solar cell according to claim 7, wherein the cleaning agent comprises the HF and the HCl with a volume ratio of 3:1.

10. The method for preparing the solar cell according to claim 5, wherein after the cleaning the silicon wafer (10) using the cleaning agent, a second oxide layer is formed on a surface of the silicon wafer (10), and the boron or phosphorus diffusion process is performed on the silicon wafer (10) formed with the second oxide layer on a surface thereof.

11. The method for preparing the solar cell according to claim 10, wherein the method of forming the second oxide layer comprises: purging the silicon wafer with ozone.

## Patentansprüche

1. Verfahren zur Herstellung einer Solarzelle, wobei das Herstellungsverfahren Folgendes umfasst: die sequentielle Durchführung eines Texturierungsprozesses und eines Bor- oder Phosphordiffusionsprozesses, wobei das Herstellungsverfahren weiter zwischen dem Texturierungsprozess und dem Bor- oder Phosphordiffusionsprozess Folgendes umfasst:
Erhitzen eines Siliziumwafers (10), der nasstexturierten in eine Waferkassette eingelegt wurde, um auf der Vorder- und Rückseite des Siliziumwafers (10) eine erste Oxidschicht (30) zu bilden, die Verunreinigungen im Siliziumwafer (10) absorbiert; und
Entfernen der ersten Oxidschicht auf der Vorder- und Rückseite des Siliziumwafers (10);
**dadurch gekennzeichnet, dass** das Erhitzungsverfahren Folgendes umfasst: Erhitzen des texturierten Siliziumwafers (10) in einer reinen Sauerstoffatmosphäre auf eine erste voreingestellte Temperatur und Halten der Temperatur für eine erste voreingestellte Zeit;
wobei die erste voreingestellte Temperatur im Bereich von 600 °C bis 800 °C liegt und die erste voreingestellte Zeit im Bereich von 30 s bis 60 s liegt.

2. Verfahren zur Herstellung der Solarzelle nach Anspruch 1, wobei die Dicke der ersten Oxidschicht (30) im Bereich von 4 nm bis 5 nm liegt.

3. Verfahren zur Herstellung der Solarzelle nach Anspruch 1, wobei es sich bei dem Siliziumwafer (10) um einen n-leitenden monokristallinen Siliziumwafer handelt und die Solarzelle einen Passivierungs-/Antireflexionsfilm, eine Passivierungsschicht, einen p-leitenden Emitter, ein n-leitendes monokristallines Siliziumwafer-Substrat, eine Tunneloxidschicht, einen n-leitenden Polysiliziumfilm und einen Antireflexionsfilm, die gestapelt sind, umfasst.

4. Verfahren zur Herstellung der Solarzelle nach Anspruch 1, wobei die erste voreingestellte Temperatur im Bereich von 700 °C bis 800 °C liegt.

5. Verfahren zur Herstellung der Solarzelle nach Anspruch 1, wobei das Verfahren zum Entfernen der ersten Oxidschicht (30) auf der Vorder- und Rückseite des Siliziumwafers (10) Folgendes umfasst: Reinigen des Siliziumwafers (10) mit einem Reinigungsmittel, wobei die Reinigungszeit im Bereich von 30 s bis 50 s liegt und das Reinigungsmittel HF umfasst.

6. Verfahren zur Herstellung der Solarzelle nach Anspruch 5, wobei das Reinigungsmittel HF mit einer Volumenkonzentration von 15 % bis 30 % umfasst.

7. Verfahren zur Herstellung der Solarzelle nach Anspruch 6, wobei das Reinigungsmittel weiter HCl umfasst.

8. Verfahren zur Herstellung der Solarzelle nach Anspruch 7, wobei das Reinigungsmittel weiter HCl mit einer Volumenkonzentration von 5 % bis 10 % umfasst.

9. Verfahren zur Herstellung der Solarzelle nach Anspruch 7, wobei das Reinigungsmittel HF und HCl in einem Volumenverhältnis von 3:1 umfasst.

10. Verfahren zur Herstellung der Solarzelle nach Anspruch 5, wobei nach der Reinigung des Siliziumwafers (10) mit dem Reinigungsmittel eine zweite Oxidschicht auf der Oberfläche des Siliziumwafers (10) gebildet wird und der Bor- oder Phosphordiffusionsprozess auf dem mit der zweiten Oxidschicht auf einer Oberfläche davon gebildeten Siliziumwafer (10) durchgeführt wird.

11. Verfahren zur Herstellung der Solarzelle nach Anspruch 10, wobei das Verfahren zur Bildung der zweiten Oxidschicht Folgendes umfasst: Spülen des Siliziumwafers mit Ozon.

## Revendications

1. Procédé de préparation d'une cellule solaire, le procédé comprenant : la réalisation en séquence d'un processus de texturation et d'un processus de diffusion de bore ou de phosphore, dans lequel le procédé comprend en outre, entre le processus de texturation et le processus de diffusion de bore ou de phosphore :
le chauffage d'une plaquette de silicium (10), qui a été texturée par voie humide et chargée dans une cassette à plaquettes, pour former une première couche d'oxyde (30) sur les deux faces avant et arrière de la plaquette de silicium (10) pour absorber les impuretés dans la plaquette de silicium (10) ; et
l'élimination de la première couche d'oxyde sur les faces avant et arrière de la plaquette de silicium (10) ;
**caractérisé en ce que** le procédé de chauffage comprend : le chauffage de la plaquette de silicium texturée (10) dans un environnement d'oxygène pur à une première température prédéfinie, et le maintien de la température pendant une première durée prédéfinie ;
dans lequel la première température prédéfinie se situe dans une plage de 600°C à 800°C, et la première durée prédéfinie se situe dans une plage de 30 s à 60 s.

2. Procédé de préparation de la cellule solaire selon la revendication 1, dans lequel l'épaisseur de la première couche d'oxyde (30) se situe dans une plage de 4 nm à 5 nm.

3. Procédé de préparation de la cellule solaire selon la revendication 1, dans lequel la plaquette de silicium (10) est une plaquette de silicium monocristallin de type n, et la cellule solaire comprend un film de passivation/antireflet, une couche de passivation, un émetteur de type p, un substrat de plaquette de silicium monocristallin de type n, une couche d'oxyde de tunnel, un film de polysilicium de type n et un film antireflet qui sont empilés.

4. Procédé de préparation de la cellule solaire selon la revendication 1, dans lequel la première température prédéfinie se situe dans une plage de 700 °C à 800 °C.

5. Procédé de préparation de la cellule solaire selon la revendication 1, dans lequel le procédé d'élimination de la première couche d'oxyde (30) sur les faces avant et arrière de la plaquette de silicium (10) comprend : le nettoyage de la plaquette de silicium (10) à l'aide d'un agent de nettoyage, dans lequel une durée de nettoyage se situe dans une plage de 30 s à 50 s, et l'agent de nettoyage comprend du HF.

6. Procédé de préparation de la cellule solaire selon la revendication 5, dans lequel l'agent de nettoyage comprend du HF dans une concentration volumique de 15 % à 30 %.

7. Procédé de préparation de la cellule solaire selon la revendication 6, dans lequel l'agent de nettoyage comprend en outre du HCl.

8. Procédé de préparation de la cellule solaire selon la revendication 7, dans lequel l'agent de nettoyage comprend en outre du HCl dans une concentration volumique de 5 % à 10 %.

9. Procédé de préparation de la cellule solaire selon la revendication 7, dans lequel l'agent de nettoyage comprend du HF et du HCl dans un rapport volumique de 3:1.

10. Procédé de préparation de la cellule solaire selon la revendication 5, dans lequel, après le nettoyage de la plaquette de silicium (10) à l'aide de l'agent de nettoyage, une seconde couche d'oxyde est formée sur une surface de la plaquette de silicium (10), et le processus de diffusion du bore ou du phosphore est effectué sur la plaquette de silicium (10) formée avec la seconde couche d'oxyde sur une surface de celle-ci.

11. Procédé de préparation de la cellule solaire selon la revendication 10, dans lequel le procédé de formation de la seconde couche d'oxyde comprend : la purge de la plaquette de silicium avec de l'ozone.
